# EUROPEAN PATENT APPLICATION

(11) **EP 3 726 563 A1**
(43) Date of publication of application: **21.10.2020**
(21) Application number: 18887844.1
(22) Date of filing: 29.11.2018
(51) Int. Cl.: H01L 21/205, C23C 16/42, C23C 16/458, H01L 21/683

(54) **FILM FORMATION DEVICE**

(30) Priority: 13.12.2017 JP 2017238854
(71) Applicant: Tokyo Electron Limited, Tokyo 107-6325 (JP)
(72) Inventor: HARASHIMA, Masayuki, Nirasaki City, Yamanashi 407-8511 (JP); NAKAMURA, Michikazu, Nirasaki City, Yamanashi 407-8511 (JP)
(74) Representative: Diehl & Partner
(86) International application number: PCT/JP2018/043961
(87) International publication number: WO 2019/116907

(57) **Abstract**

A film formation device for performing a film formation process with respect to a substrate to be treated, by heating the substrate to be treated on a mounting table and supplying treatment gas to the substrate to be treated, is provided with: a housing part which has an internal space that houses the mounting table, the treatment gas being supplied to the internal space and induction-heated; a rotating shaft part which supports the mounting table such that the mounting table is rotatable; and a raising and lowering part which raises and lowers the substrate to be treated in order to deliver the substrate to be treated between an external conveyance device for the substrate to be treated and the mounting table, wherein the rotating shaft part and/or the raising and lowering part is formed from a material having a thermal conductivity of 15 W/m·K or lower and a melting point of 1800°C or higher.

## Description

### TECHNICAL FIELD

### (CROSS-REFERENCE TO RELATED APPLICATION)

This application is based upon and claims the benefit of priority from Japanese Patent Application No. 2017-238854, filed on December 13, 2017, the entire contents of which are incorporated herein by reference.

The present disclosure relates to a film forming apparatus that performs a film forming process on a target substrate.

### BACKGROUND

In recent years, a semiconductor manufactured using a compound such as silicon carbide (SiC) or the like has been used for an electronic device such as a semiconductor power device or the like. In the manufacture of such an electronic device, a compound semiconductor film such as a SiC film or the like is formed by epitaxial growth in which a film having the same orientation relationship as a substrate crystal is grown on a monocrystalline substrate.

Patent document 1 discloses, as an apparatus for forming a SiC film by epitaxial growth, an apparatus that includes a stage on which a SiC substrate as a target substrate is placed, a rotary shaft part that rotatably supports the stage, and a susceptor having an internal space for accommodating the stage. In the film forming apparatus disclosed in Patent Document 1, the SiC film is formed on the SiC substrate by supplying a processing gas to the SiC substrate on the stage inside the susceptor while heating the SiC substrate by inductively heating the susceptor. Furthermore, the film forming apparatus of Patent Document 1 includes a heat insulating material provided between the susceptor and the stage. A heat insulating region provided with the heat insulating material is formed between the central region including the rotary shaft part inside the susceptor and the peripheral region in a plan view. The stage tends to have a low temperature in the central region and the peripheral region. Thus, the heat insulating region is formed as described above, and the temperature of the stage above the heat insulating region is reduced, thereby reducing the temperature variation in the plane of the SiC substrate on the stage.

### [Prior Art Document]

### Patent Document

Patent Document 1: Japanese laid-open publication No. 2016-100462

By reducing the temperature variation in the plane of the SiC substrate on the stage as in the film forming apparatus disclosed in Patent Document 1, it is expected that defects occurring in a low-temperature portion of the SiC substrate can be suppressed. In addition, by reducing the temperature variation in the plane of the SiC substrate as described above, it is possible to suppress a variation in impurity concentration in the plane of the SiC substrate. However, the film forming apparatus of Patent Document 1 has room for improvement in terms of heating efficiency because the heat insulating material is provided between the susceptor as a heating source and the stage as an object to be heated. In addition, the heat of the stage escapes through the rotary shaft part connected to the center of the stage. This leads to a problem in that the in-plane temperature distribution of the stage becomes non-uniform, and thus, the in-plane temperature distribution of the target substrate becomes non-uniform.

The present disclosure provides some embodiments of a film forming apparatus capable of reducing a temperature variation in the plane of a target substrate with high heating efficiency.

### SUMMARY

According to one embodiment of the present disclosure, there is provided a film forming apparatus for heating a target substrate on a stage, supplying a processing gas to the target substrate, and performing a film forming process on the target substrate, including: an accommodation part having an internal space for accommodating the stage, wherein the processing gas is supplied to the internal space and is inductively heated; a rotary shaft part configured to rotatably support the stage; and an elevating part configured to raise and lower the target substrate to deliver the target substrate between an external substrate transfer device and the stage, wherein the rotary shaft part and/or the elevating part is formed of a material having a thermal conductivity of 15 W/m·K or less and a melting point of 1,800 degrees C or higher.

In one embodiment of the film forming apparatus of the present disclosure, a heat insulating material is not provided between the susceptor serving as a heating source and the stage serving as a heated object. Therefore, it is possible to heat the target substrate with high heating efficiency. Furthermore, since the rotary shaft part and/or the elevating part are formed of a material having a thermal conductivity of 15 W/m K or less, the temperature at the center of the stage does not decrease. Therefore, as compared with a case where the rotary shaft part and the like are formed of a material having a high thermal conductivity, it is possible to reduce the temperature difference between the central region of the stage and the region around the central region of the stage. Thus, it is possible to reduce the temperature variation in the plane of the target substrate.

According to one embodiment of the present disclosure, it is possible to reduce a temperature variation in the plane of a target substrate with high heating efficiency.

### BRIEF DESCRIPTION OF DRAWINGS

FIG. 1 is a view schematically showing an outline of a configuration of a film forming apparatus according to an embodiment of the present disclosure.
FIG. 2 is a sectional view schematically showing an outline of an internal configuration of a processing container in the film forming apparatus shown in FIG. 1.
FIG. 3 is a view showing the results of verification test 1.
FIG. 4 is a plan view illustrating a state in which a SiC substrate is placed on a holder during film formation in verification test 2.

### DETAILED DESCRIPTION

Hereinafter, an embodiment of the present disclosure will be described with reference to the drawings. In the subject specification and the drawings, components having substantially identical functions and configurations will be denoted by the same reference numerals with the duplicate descriptions thereof omitted.

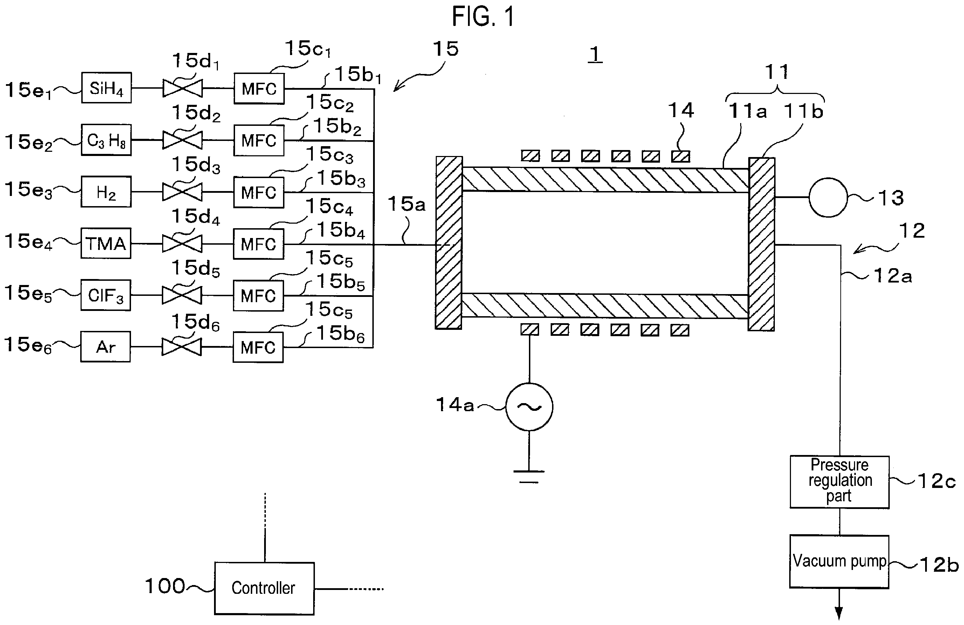

FIG. 1 is a view schematically showing an outline of a configuration of a film forming apparatus according to an embodiment of the present disclosure.

A film forming apparatus 1 in FIG. 1 includes a substantially rectangular parallelepiped processing container 11. An exhaust line 12 is connected to the processing container 11. The processing container 11 can be adjusted to be maintained in a predetermined depressurized state (pressure) through the exhaust line 12. The exhaust line 12 is provided with an exhaust pipe 12a having one end connected to the processing container 11. The exhaust pipe 12a is configured by an exhaust manifold and the like, and includes a vacuum pump 12b such as a mechanical booster pump or the like connected to the side of the exhaust pipe 12a opposite the processing container 11. In the exhaust pipe 12a between the processing container 11 and the vacuum pump 12b, there is provided a pressure regulation part 12c composed of an APC (automatic pressure control) valve, a proportional control valve or the like and configured to regulate an internal pressure of the processing container 11. Furthermore, a pressure gauge 13 is provided in the processing container 11. The regulation of the internal pressure of the processing container 11 by the pressure regulation part 12c is performed based on the measurement result of the pressure gauge 13.

The processing container 11 includes a hollow rectangular column-shaped processing container body 11a having openings at both ends thereof, and sidewall portions 11b connected to the both ends of the processing container body 11a so as to close the openings. The processing container body 11a and the sidewall portions 11b are made of a dielectric material such as quartz or the like.

A coil 14 connected to a high-frequency power source 14a is provided outside the processing container body 11a. The coil 14 inductively heats a target substrate, a susceptor 23 (to be described later) and the like inside the processing container 11.

The processing container 11 is configured so that a raw material gas serving as a raw material for film formation or the like is supplied into the processing container 11 by a gas supply line 15. The gas supply line 15 includes a gas supply pipe 15a connected to the processing container 11, and gas supply pipes 15b₁ to 15b₆ connected to the gas supply pipe 15a.

The gas supply pipes 15b₁ to 15b₆ are provided with mass flow controllers (MFCs) 15c₁ to 15c₆ and valves 15d₁ to 15d₆, respectively. A gas source 15e₁ is connected to the gas supply pipe 15bi, and a SiH₄ gas is supplied from the gas source 15ei. Similarly, gas sources 15e₂ to 15e₆ are connected to the gas lines 15b₂ to 15b₆, respectively. A C₃H₈ gas, a H₂ gas, a TMA (trimethylaluminum) gas, a ClF₃ gas and an Ar gas are supplied from the respective gas sources 15e₂ to 15e₆.

In a case in which a p-type SiC film is formed by epitaxial growth on a SiC substrate as a target substrate, the SiH₄ gas, the C₃H₈ gas, the H₂ gas and the TMA gas as raw material gases for film formation are supplied from the respective gas supply pipes 15b₁ to 15b₄ into the processing container 11. A gas source and a gas supply pipe for an N₂ gas may be provided to form an n-type SiC film. In addition, when removing foreign substances adhering to a structure in the processing container 11, for example, one of the ClF₃ gas, the H₂ gas and the Ar gas or a mixture of two or more of these gases is supplied from the gas supply pipes 15b₃, 15bs and 15b₆ into the processing container 11.

Furthermore, the film forming apparatus 1 includes a controller 100. The controller 100 is, for example, a computer, and includes a program storage part (not shown). The program storage part stores programs for executing a film forming process by controlling the MFCs 15c₁ to 15c₆, the valves 15d₁ to 15d₆, the high-frequency power source 14a, the pressure regulation part 12c, a below-described rotary driving part, a below-described vertical driving part, and the like.

The above programs may be recorded in a computer-readable storage medium such as, for example, a computer-readable hard disk (HD), a flexible disk (FD), a compact disk (CD), a magneto-optical disk (MO), a memory card or the like, and may be installed on the controller 100 from the storage medium.

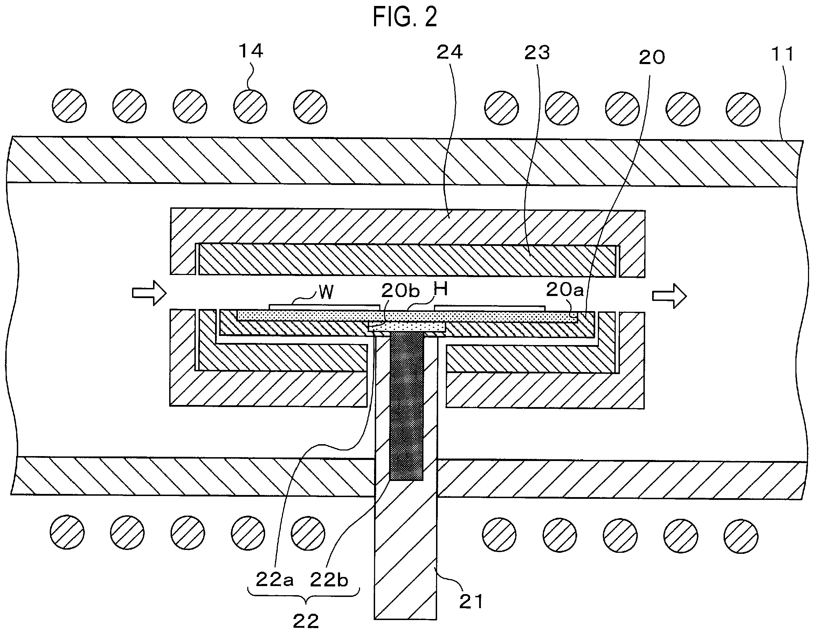

Next, an internal configuration of the processing container 11 will be described. FIG. 2 is a sectional view schematically showing an outline of the internal configuration of the processing container 11 in the film forming apparatus 1 of FIG. 1. As shown in FIG. 2, inside the processing container 11, there is provided a stage 20 on which SiC substrates W (hereinafter referred to as substrates W) as target substrates are placed via a holder H, a rotary shaft part 21 that rotates and supports the stage 20, and an elevating part 22 that raises and lowers the holder H on which the substrates W is placed. In addition, a susceptor 23 as an accommodation part is provided inside the processing container 11. The susceptor 23 has an internal space for accommodating the stage 20. A processing gas is supplied into the internal space so that the processing gas flows from one end of the stage 20 to the other end of the stage 20 through the center of the stage 20.

The holder H is configured to collectively load and unload a plurality of substrates W into and out of the film forming apparatus 1 and is configured to hold the plurality of substrates W. Furthermore, the holder H is formed of a conductive material which has high heat resistance and which can be easily heated by inductive heating. For example, the holder H is formed of a graphite-made member whose upper surface on which the substrates W are placed is coated with SiC. The holder H is formed in, for example, a disk shape having a smaller diameter than the stage 20.

The stage 20 is formed in a disk shape having a downwardly-recessed concave portion 20a formed on the upper surface thereof, and is provided horizontally inside the processing container 11. The holder H fits into the concave portion 20a. Furthermore, a downwardly-recessed depression 20b is formed at the center of the bottom of the concave portion 20a. A support portion 22a described later fits into the depression 20b. As the stage 20 is rotated by the rotary shaft part 21, the holder H is also rotated. The stage 20 is made of a conductive material which has high heat resistance and which can be easily heated by inductive heating. The stage 20 is formed of, for example, a graphite-made member whose upper surface is coated with SiC.

One end of the rotary shaft part 21 is connected to the center of the lower portion of the stage 20, and the other end thereof penetrates through the bottom of the processing container 11 and extends downward. The rotary shaft part 21 is connected to a rotary driving mechanism (not shown). As the rotary shaft part 21 is rotated by the rotary driving mechanism, the stage 20 is rotated.

The rotary shaft part 21 is formed of a material having a relatively low thermal conductivity and a relatively high electrical resistivity. Specifically, the rotary shaft part 21 is formed of a material having a thermal conductivity of 15 W/m·K or less, a melting point of 1,800 degrees C or more and an electrical resistivity of 10 to 50 µΩ·m. More specifically, the rotary shaft part 21 is formed of a carbon-fiber-reinforced carbon composite material. As the carbon-fiber-reinforced carbon composite material, it may be possible to use, for example, CX-31 manufactured by Toyo Tanso Co., Ltd. in which a thermal conductivity in a direction parallel to a fiber axis is 31 W/m K, a thermal conductivity in a direction perpendicular to the fiber axis is 12 W/m K, and the electrical resistivity is 22 µΩ·m. When the CX-31 is used, the rotary shaft part 21 is formed so that the direction perpendicular to the fiber axis and the axial direction of the rotary shaft part 21 are parallel.

The elevating part 22 is used for delivering the substrates W between a substrate transfer device provided outside the film forming apparatus 1 and the stage 20. In this example, the elevating part 22 delivers the holder H on which the substrates W are placed. The elevating part 22 includes the support portion 22a formed in a disc shape smaller in diameter than the holder H and configured to support the holder H, and an elevating shaft 22b connected to the lower surface of the support portion 22a and configured to raise and lower the support portion 22a. The elevating shaft 22b is raised and lowered by a vertical driving mechanism (not shown) so that the holder H (namely the substrates W) is raised and lowered. The support portion 22a and the elevating shaft 22b are formed of the same material as that of the rotary shaft part 21. As will be described later, by forming the rotary shaft part 21, the support portion 22a and the elevating shaft 22b with a material having a thermal conductivity of 15 W/m K or less, such as a carbon-fiber-reinforced carbon composite material, it is possible to improve the in-plane uniformity of the temperature of the substrates W.

The susceptor 23 is formed in a rectangular parallelepiped shape having openings formed in two surfaces facing each other, and has a structure in which a processing gas is supplied from the opening formed in one surface and is discharged from the opening formed in the other surface. In this structure, the processing gas supplied to the substrates W are supplied and discharged along a direction parallel to the substrates W. The susceptor 23 is made of a conductive material which has a high heat resistance and which can be easily heated by inductive heating. For example, the susceptor 23 is formed of a graphite-made member whose surface on the side of the substrate W is coated with SiC.

Furthermore, a heat insulating material 24 for insulating the susceptor 23 and the processing container 11 from each other is provided on the outer periphery of the susceptor 23. The heat insulating material 24 is formed by using, for example, a fibrous carbon material having a high porosity. Although not shown, a holding structure for holding the heat insulating material 24 while keeping the heat insulating material 24 spaced apart from the processing container 11 is provided outside the heat insulating material 24.

Next, a substrate process including the film forming process, which makes use of the film forming apparatus 1, will be described. First, the holder H on which the substrates W are placed is loaded into the processing container 11 (step S1). Specifically, the holder H is loaded from the outside of the film forming apparatus 1 into the processing container 11 via a gate valve (not shown) by using a transfer means (not shown) provided outside the film forming apparatus 1, and is positioned above the stage 20. Subsequently, the elevating part 22 is raised to support the holder H with the support portion 22a. Then, the transfer means is retracted from the processing container 11, and the elevating part is lowered to place the holder H on the stage 20.

After loading the holder H, a raw material gas is supplied into the processing container 11, and the substrate W is heated by applying high-frequency power from the high-frequency power source 14a to the coil 14, thereby forming a p-type SiC film on the substrates W by epitaxial growth (step S2). Specifically, the valves 15d₁ to 15d₄ are opened, and the SiH₄ gas, the C₃H₈ gas, the H₂ gas and the TMA gas are supplied into the processing container 11 while adjusting the flow rates of the gases by the MFCs 15c₁ to 15c₄. Furthermore, by applying the high-frequency power from the high-frequency power source 14a to the coil 14, the substrate W is heated by radiation or heat conduction generated from the holder H, the stage 20 and the susceptor 23, which have been inductively heated. During the film formation, the internal pressure of the processing container 11 is, for example, 10 Torr to 600 Torr, and the temperature of the substrate W is, for example, 1,500 degrees C to 1,700 degrees C.

After the film formation is completed, the holder H supporting the substrates W is unloaded out of the processing container 11 (step S3). Specifically, after closing the valves 15d₁ to 15d₄ to stop the supply of the raw material gases, the elevating part 22 is raised to raise the holder H on which the substrates W are supported. Then, the transfer means outside the film forming apparatus 1 is inserted into the processing container 11 via the gate valve, and is positioned below the support portion 22a of the elevating part 22. Thereafter, the elevating part 22 is lowered, the holder H is delivered from the support portion 22a to the transfer means, and the transfer means is retracted from the processing container 11, whereby the holder H holding the substrates W is unloaded from the processing container 11. While the supply of the high-frequency power to the coil 14 may be interrupted during the unloading of the substrates W, it is preferred that the high-frequency power is supplied to the coil 14 while controlling the temperature of the stage 20 and the susceptor 23 to be optimal in a subsequent step.

After the unloading of the holder H, the process returns to step S1 in which the holder H on which other substrates W are placed is loaded into the processing container 11. The processes of steps S1 to S3 are repeated.

Subsequently, the effects of the film forming apparatus 1 of the present embodiment will be described. In an apparatus for forming a SiC film with the same configuration as that of the film forming apparatus 1, it is known that the temperature of the stage and the temperature of the holder are low in a central region in a plan view (hereinafter abbreviated as central region). The present inventors have conducted intensive studies and found that one of the causes of the low temperature of the stage and the low temperature of the holder in the central region is a material of the member located in the central region. Details thereof are as follows.

In the conventional film forming apparatus, those components corresponding to the rotary shaft part 21 and the elevating part 22 located in the central region of the film forming apparatus 1 of the present embodiment are formed of SiC or graphite. Although the thermal conductivity of SiC or graphite is lower than that of a metallic material or the like, it is at a relatively high level of 100 W/m·K or more. Therefore, in the conventional film forming apparatus, even if the stage or the holder is heated, the heat of the central portion of the stage or the holder is dissipated through the rotary shaft part and the elevating part. As a result, it is considered that the temperature of the stage or the holder is low in the central portion of the stage or the holder. The term "central portion" refers to a portion located in the central region and positioned above the rotary shaft part and the elevating part.

On the other hand, in the film forming apparatus 1 of the present embodiment, the thermal conductivity of the rotary shaft part 21 and the elevating part 22 located in the central region is at a low level of 15 W/m·K. Therefore, when the stage 20 or the holder H is heated, the heat of the central portion of the stage 20 or the holder H is not dissipated through the rotary shaft part 21 and the elevating part 22. Thus, it is possible to prevent the temperature of the stage 20 or the holder H from decreasing in the central portion of the stage 20 or the holder H. Furthermore, the electrical resistivity of the rotary shaft part 21 and the elevating part 22 is at a relatively low level of 10 to 50 µΩ·m. Therefore, the fact that the temperature of the rotary shaft part 21 and the elevating part 22 is increased by inductive heating is considered to be one of the reasons why the temperature of the central portion of the stage 20 or the holder H can be prevented from being lowered.

Therefore, in the film forming apparatus 1 of the present embodiment, the in-plane uniformity of the temperature of the substrate W placed on the stage 20 so as to cover or to extend over the central portion of the stage 20 is improved. As a result of improving the in-plane uniformity of the temperature of the substrate W, the following effects (1) to (3) may be obtained.

### (1) Suppression of Defect Generation

In the film forming apparatus 1 of the present embodiment, even if the substrate W is placed on the stage 20 so as to cover or to extend over the central portion of the stage 20, for example, even if the substrate W is 6 inches in diameter and has to be placed so as to cover or extend over the central portion, the temperature of the portion of the substrate W (hereinafter sometimes abbreviated as a central position portion of the substrate W) covering or extending over the central portion does not decrease. For this reason, it is possible to suppress the generation of defects (for example, triangular defects or basal plane dislocation defects) due to heat and thermal stress in the central position portion of the substrate W.

### (2) Improvement of Film Thickness Uniformity in Low-Speed Growth

The deposition rate of a film at the time of film formation has a small temperature dependency, and the etching rate by the H₂ gas at the time of film formation has a large temperature dependency proportional to a temperature. When film formation is performed at a low speed to form a thin film or the like, there is no large difference between the film deposition rate at the time of film formation and the etching rate by the H₂ gas at the time of film formation. Therefore, in the case of the low-speed film formation, if the temperature of the central portion of the stage or the holder is low as in the related art, the film thickness on the central position portion of the target substrate increases. On the other hand, in the present embodiment, the temperature in the central position portion of the substrate W does not decrease. Therefore, the in-plane uniformity of the film thickness can be improved in the low-speed film formation.

### (3) Improvement of Impurity Concentration Uniformity During Formation of p-Type SiC Film

In the case of forming a p-type SiC film using aluminum (Al) as a dopant, the concentration of impurities taken into the SiC film is high in a region where the SiC substrate has a low temperature, and is low in a region where the SiC substrate has a high temperature. In the present embodiment, the temperature at the central position portion of the substrate W does not decrease. Therefore, it is possible to improve the in-plane uniformity of the impurity concentration in the formation of the p-type SiC film.

By the way, a process of removing deposits on the susceptor 23 using a ClF₃ gas has temperature dependency. Furthermore, the temperature of the susceptor 23 is affected by the radiant heat of the stage 20 facing the susceptor 23. In the film forming apparatus 1 of the present embodiment, the temperature of the central portion of the stage 20 does not decrease as described above. Therefore, the temperature of the central portion of the susceptor 23 facing the central portion of the stage 20 does not decrease. Thus, it is possible to uniformly remove the deposits on the susceptor 23 in-plane throughout.

Furthermore, in the film forming apparatus 1 of the present embodiment, the temperature of the central portion of the holder H does not decrease as described above. Therefore, it is possible to reduce the thermal stress acting on the holder H during film formation. Accordingly, it is possible to prevent the holder H from warping and to prevent the flow of the raw material gas from being disturbed during the film forming process.

Furthermore, in this embodiment, the rotary shaft part 21 and the elevating part 22 are formed of a carbon-fiber-reinforced carbon composite material. Therefore, as in the case of being formed of SiC or graphite, the rotary shaft part 21 and the elevating part 22 have excellent heat resistance, resistant to the H₂ gas and the ClF₃ gas, and high in mechanical strength. Furthermore, since the rotary shaft part 21 and the elevating part 22 are formed of a carbon-fiber-reinforced carbon composite material and have a low impurity concentration, they do not become unnecessary impurity sources during film formation.

Moreover, the carbon-fiber-reinforced carbon composite material is less expensive than SiC. Therefore, the cost can be reduced by forming the rotary shaft part 21 and the elevating part 22 with the carbon-fiber-reinforced carbon composite material.

In addition, in the present embodiment, the melting point of the material of the rotary shaft part 21 and the like of the film forming apparatus 1 is 1,800 degrees C or higher, which is lower than the maximum temperature of the substrate W in the substrate process performed using the film forming apparatus 1. Therefore, the rotary shaft part 21 does not melt during the substrate process.

In the above description, the rotary shaft part 21, and the support portion 22a and the elevating shaft 22b of the elevating part 22 are all formed of a material having a low thermal conductivity, such as a carbon-fiber-reinforced carbon composite material or the like. However, the present disclosure is not limited to this example. At least one of the rotary shaft part 21, the support portion 22a and the elevating shaft 22b may be formed of a material having a low thermal conductivity, such as a carbon-fiber-reinforced carbon composite material or the like.

### Examples

### (Verification Test 1)

A verification test was performed to verify the in-plane temperature distribution of the holder H. In this verification test (hereinafter referred to as Verification Test 1), substrates W were arranged along the radial direction of the holder H, and etching using a H₂ gas was performed. The temperature distribution in the holder H was calculated from the relational expression between a temperature-dependent etching amount and a temperature. The rotary shaft part 21, the support portion 22a and the elevating shaft 22b are located in regions radially spaced apart by 140 mm to 160 mm from the edge of the holder H.

In Example 1, the H₂ gas-based etching was performed in the film forming apparatus 1 described with reference to FIG. 1. In Example 2, the aforementioned etching was performed in a film forming apparatus different from the above-described film forming apparatus 1 only in that the support portion 22a is formed of graphite and the elevating shaft 22b is formed of SiC. In Comparative Example 1, the aforementioned etching was performed in a film forming apparatus different from the above-described film forming apparatus 1 only in that the rotary shaft part 21 and the elevating shaft 22b are formed of SiC and the support portion 22a is formed of graphite.

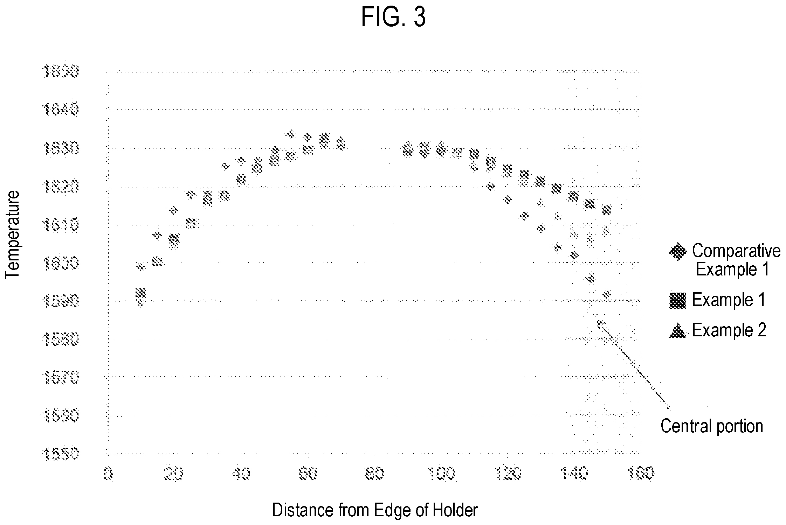

As shown in FIG. 3, in Comparative Example 1 in which the rotary shaft part 21, the support portion 22a and the elevating shaft 22b are formed of SiC, a temperature difference between a portion of the substrate W located in an intermediate region between the central portion and the peripheral edge portion of the holder H and a portion of the substrate W located at the central portion of the holder H was 40 degrees C or higher. On the other hand, in Example 1 in which the rotary shaft part 21, the support portion 22a and the elevating shaft 22b are formed of a carbon-fiber-reinforced carbon composite material, the temperature difference in the substrate W was 20 degrees C or lower. Also in Example 2 in which the rotary shaft part 21 is formed of a carbon-fiber-reinforced carbon composite material, the temperature difference in the substrate W was about 30 degrees C. That is, by forming at least the rotary shaft part 21 among the rotary shaft part 21, the support portion 22a and the elevating shaft 22b with a carbon-fiber-reinforced carbon composite material, it is possible to improve the in-plane uniformity of the temperature of the substrate W.

The temperature of the portion of the substrate W located at the peripheral edge portion of the holder H is low because a processing gas introduction port and a processing gas exhaust port are provided near the peripheral edge portion of the holder H and because the heat at the peripheral edge portion of the holder is taken away by the processing gas.

### (Verification Test 2)

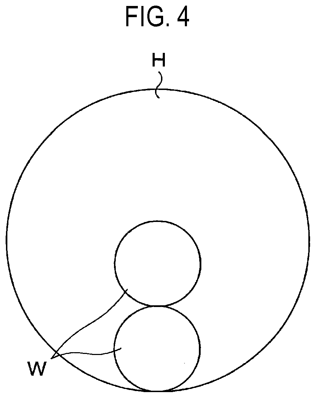

A verification test was performed to verify the defect generation suppression in the portion of the substrate W covering or extending over the central portion of the stage 20. In this verification test (Verification Test 2), as shown in FIG. 4, a SiC film was formed by placing one substrate W having a diameter of 3 inches (hereinafter referred to as inner substrate W) so as to extend over the central portion of the holder H having a diameter of 300 mm, and placing the other substrate W having a diameter of 3 inches (hereinafter referred to as outer substrate W) radially outward of the inner substrate W. Basal plane dislocation defects in the formed SiC film was detected by a photoluminescence method. In Example 3, a film was formed by the film forming apparatus 1 in which the rotary shaft part 21, the support portion 22a and the elevating shaft 22b are formed of a carbon-fiber-reinforced carbon composite material as described with reference to FIG. 1 and the like. On the other hand, in Comparative Example 2, a film was formed by a film forming apparatus different from the film forming apparatus 1 only in that the rotary shaft part 21 and the elevating shaft 22b are formed of SiC and the support portion 22a is formed of graphite. In Example 3 and Comparative Example 2, the substrates W of the same lot were used. The following number of defects is the number of defects per one 3-inch wafer.

In Comparative Example 2, there was no large difference in the number of defects in the formed SiC film between the inner substrate W and the outer substrate W. The number of defects was about 2,500 in both the inner substrate W and the outer substrate W. On the other hand, in Example 3, the number of defects in the SiC film formed on the outer substrate W was 2,700, which is not changed from that of Comparative Example 2. However, the number of defects in the SiC film formed on the inner substrate W was about 1,600, which is significantly smaller than that of Comparative Example 3. As is apparent from these results, in the film forming apparatus 1 of the present embodiment, it is possible to suppress the generation of defects at the central position portion of the substrate W.

### (Verification Test 3)

A verification test was performed to verify the durability of the rotary shaft part 21, the support portion 22a and the elevating shaft 22b, which are formed of a carbon-fiber-reinforced carbon composite material. In this verification test (Verification Test 3), first, the unused rotary shaft part 21, the unused support portion 22a and the unused elevating shaft 22b, which are formed of a carbon-fiber-reinforced carbon composite material, were exposed to an H₂ atmosphere. Then, when the exposure time exceeded 400 minutes or more, a variation in mass of each of the rotary shaft part 21, the support portion 22a and the elevating shaft 22b from the non-use time was calculated. Thereafter, the above-described removal process using a ClF₃ gas was performed for one hour, and a variation in mass of each of the rotary shaft part 21, the support portion 22a and the elevating shaft 22b before and after the removal process was calculated. The H₂ gas-based annealing process was performed in an H₂ gas atmosphere at 1,600 degrees C or higher, and the removal process was performed in a ClF₃ gas atmosphere at 500 degrees C or higher.

In Verification Test 3, the variation in mass of each of the rotary shaft part 21, the support portion 22a and the elevating shaft 22b by the H₂ gas-based annealing process was -0.03 g or less, -0.02 g or less and -0.005 g or less. The variation in mass of each of the rotary shaft part 21, the support portion 22a and the elevating shaft 22b by the ClF₃ gas-based removal process was -0.002 g or less, 0 g and 0.003 g or less. As is apparent from these results, the rotary shaft part 21, the support portion 22a and the elevating shaft 22b formed of a carbon-fiber-reinforced carbon composite material are not eroded by the high-temperature H₂ gas and the high-temperature ClF₃ gas.

While the embodiment of the present disclosure has been described above, the present disclosure is not limited thereto. It is clear that a person skilled in the art may conceive various changes or modifications within the scope of the technical idea recited in the claims. It is to be understood that these changes or modifications fall within the technical scope of the present disclosure.

### INDUSTRIAL USE OF THE PRESENT DISCLOSURE

The present disclosure is useful for a technique of forming a SiC film by epitaxial growth.

### EXPLANATION OF REFERENCE NUMERALS

1: film forming apparatus, 11: processing container. 14: coil, 14a: high-frequency power source, 15: gas supply line, 20: stage, 21: rotary shaft part, 22: elevating part, 22a: support portion, 22b: elevating shaft, 23: susceptor, 24: heat insulating material, 100: controller, W: SiC substrate

## Claims

1. A film forming apparatus for heating a target substrate on a stage, supplying a processing gas to the target substrate, and performing a film forming process on the target substrate, comprising:
an accommodation part having an internal space for accommodating the stage, wherein the processing gas is supplied to the internal space and is inductively heated;
a rotary shaft part configured to rotatably support the stage; and
an elevating part configured to raise and lower the target substrate to deliver the target substrate between an external substrate transfer device and the stage,
wherein the rotary shaft part and/or the elevating part is formed of a material having a thermal conductivity of 15 W/m·K or less and a melting point of 1,800 degrees C or higher.

2. The apparatus of Claim 1, wherein the material has an electrical resistivity of 10 to 50 µΩ·m.

3. The apparatus of Claim 1, wherein the material is a carbon-fiber-reinforced carbon composite material.

4. The apparatus of Claim 1, wherein the accommodation part is formed from a silicon carbide and/or a graphite.

5. The apparatus of Claim 1, wherein the internal space of the accommodation part is heated to 1,600 degrees C or higher by the inductive heating.

6. The apparatus of Claim 1, wherein a SiC film is formed by the film forming process.
